# EUROPÄISCHE PATENTANMELDUNG

(11) **EP 0 688 157 A2**
(43) Veröffentlichungstag der Anmeldung: **20.12.1995**
(21) Anmeldenummer: 95201544.4
(22) Anmeldetag: 12.06.1995
(51) Int. Cl.: H05K 7/14

(54) **Gehäuse für elektronische Steckbaugruppen**

(30) Priorität: 16.06.1994 DE 4420983
(71) Anmelder: Philips Patentverwaltung GmbH, 22335 Hamburg (DE); Philips Electronics N.V., 5621 BA Eindhoven (NL)
(72) Erfinder: Banik,Joachim, c/o Philips, D-20097 Hamburg (DE); Menkhaus, Peter, c/o Philips, D-20097 Hamburg (DE)
(74) Vertreter: Erdmann, Anton, Dipl.-Ing.

(57) **Zusammenfassung**

Die Erfindung bezieht sich auf ein Gehäuse für elektronische Steckbaugruppen (18), die von der Gehäusefrontseite her einschiebbar sind und im Bereich der Gehäuserückwand (10a) über Steckverbinder (22) kontaktierbar ausgebildet sind, wobei die Steckverbinder (22) auf ein Anschlußfeld (25, 26) herausgeführt sind. Zur Vereinfachung der Verdrahtung wird vorgeschlagen, daß das Anschlußfeld (25, 26) auf einer von der Rückwand (10a) getrennten, mit Kabelverbindern (25) versehenen gesonderten Anschlußleiterplatte (26) ausgebildet ist und daß die Kabelverbinder (25) elektrisch über eine flexible Leitung (24) mit den Steckverbindern (22) verbunden sind.

## Beschreibung

Die Erfindung bezieht sich auf ein Gehäuse für elektronische Steckbaugruppen, die von der Gehäusefrontseite her einschiebbar und im Bereich der Gehäuserückwand über Steckverbinder kontaktierbar ausgebildet sind, wobei die Steckverbinder auf ein Anschlußfeld herausgeführt sind.

Das genannte Anschlußfeld dient für die externe Verkabelung. Dabei sind die genannten Steckverbinder in der Regel auf einer gesonderten Rückwandleiterplatte angeordnet. Oft ist das Anschlußfeld Bestandteil der Rückwandleiterplatte, sei es, daß die Leiterplattenfläche nach oben, unten, links oder rechts zur Aufnahme der Kabelanschlüsse verlängert ist oder daß auf der dem Gehäuseinnenraum abgewandten Seite der Rückwandleiterplatte verkabelt wird. Nachteil derartiger Bauarten ist eine in der Regel schlechte Zugänglichkeit des Anschlußfeldes.

Durch die DE-OS 41 14 484 ist z.B. ein Baugruppenträger mit einem Gehäuse der eingangs genannten Art bekannt geworden. Dabei tragen die Leiterplatten an ihren rückseitigen Enden Messerleisten, die in gehäuseseitige Federleisten eingreifen, wenn die entsprechende Baugruppe in ihre Endposition eingeschoben wird. Dabei sind die Federleisten an mittleren Profilschienen des Baugruppenträgers befestigt. Dadurch ergibt sich auf der Rückseite des Baugruppenträgers hinter den Federleisten bis zu einer Gehäuserückwand ein abgeschirmter Raum für die Verdrahtung.

Der Erfindung liegt die Aufgabe zugrunde, bei einem Gehäuse der eingangs genannten Art die Verdrahtung für die externen Kabel zu vereinfachen und zu erleichtern.

Diese Aufgabe wird gemäß der Erfindung bei einem Gehäuse der eingangs genannten Art dadurch gelöst, daß das Anschlußfeld auf einer von der Rückwand getrennten, mit Kabelverbindern versehenen gesonderten Anschlußleiterplatte ausgebildet ist und daß die Kabelverbinder elektrisch über ein flexibles Kabel mit den Steckverbindern verbunden sind. Die von der Rückwand bzw. von einer Rückwandleiterplatte getrennt als gesondertes Bauteil ausgebildete Anschlußleiterplatte kann somit durch einen einfachen Handgriff an einer für den Monteur leicht zugänglichen Stelle untergebracht werden. Damit kann die Verkabelung schnell, leicht und problemlos durchgeführt werden. Ein umständliches Verkabeln im Bereich der möglicherweise schlecht zugänglichen Rückwand entfällt somit.

In Ausgestaltung der Erfindung ist das Gehäuse gekennzeichnet durch einen die Steckbaugruppen aufnehmenden Leiterplattenbauraum und einen davon getrennten, die Anschlußleiterplatte und die Verkabelung aufnehmenden Anschlußbauraum. Dadurch ergibt sich eine klare Trennung zwischen dem Leiterplattenbauraum einerseits und dem Anschlußbauraum andererseits, der vorzugsweise unterhalb des Leiterplattenbauraumes angeordnet ist.

In einer weiteren Ausgestaltung der Erfindung ist die Anschlußleiterplatte an der Frontseite oder im Bereich einer Seitenwand des Gehäuses angeordnet. Damit ergibt sich die Möglichkeit, den Kabelanschluß sowohl von vorn als auch von einer Seite aus durchzuführen, je nachdem, wie das Gehäuse montiert wird.

Dabei ist in einer weiteren Ausgestaltung der Erfindung vorgesehen, daß der Anschlußbauraum an der Frontseite des Gehäuses mit parallel zur Frontseite verlaufenden Nuten zur Aufnahme der Anschlußleiterplatte versehen ist. Diese Bauweise ermöglicht ein einfaches Einschieben der Anschlußleiterplatte von der Seite her.

Wenn die Verdrahtung bei einer entsprechenden Montage des Gehäuses nicht von vorn, sondern von der Seite her erfolgen soll, so ist in einer weiteren Ausgestaltung der Erfindung vorgesehen, daß der Anschlußbauraum im Bereich einer Seitenwand mit Befestigungselementen, z.B. mit Schnapphaken, zur Aufnahme der Anschlußleiterplatte versehen ist. Diese Bauweise ermöglicht somit eine einfache Montage der Anschlußleiterplatte von der Seite her.

In weiterer Ausgestaltung der Erfindung ist vorgesehen, daß der Leiterplattenbauraum durch einen Frontdeckel und der Anschlußbauraum durch einen Front- und/oder einen Seitendeckel verschließbar ist.

Weitere zweckmäßige Ausgestaltungen der Erfindung sind in den Unteransprüchen und in der nachfolgenden Zeichnungsbeschreibung erläutert.

Die Fig. 1 bis 7 zeigen perspektivisch dargestellte Ausführungsbeispiele des Gegenstandes gemäß der Erfindung.
Fig. 1 zeigt ein allseits geschlossenes Gehäuse,
Fig. 2 zeigt das gleiche Gehäuse, von seiner Schmalseite her zugänglich,
Fig. 3 zeigt das gleiche Gehäuse, von seiner Breitseite her zugänglich,
Fig. 4 zeigt das Gehäuse in einer Explosionsdarstellung,
Fig. 5 zeigt das geöffnete Gehäuse mit frontseitig angeordneten Anschlußkontakten,
Fig. 6 zeigt das Gehäuse mit seitlich angeordneten Anschlußkontakten, und
Fig. 7 zeigt das Gehäuse in einer anderen Lage mit oben angeordneten Anschlußkontakten.

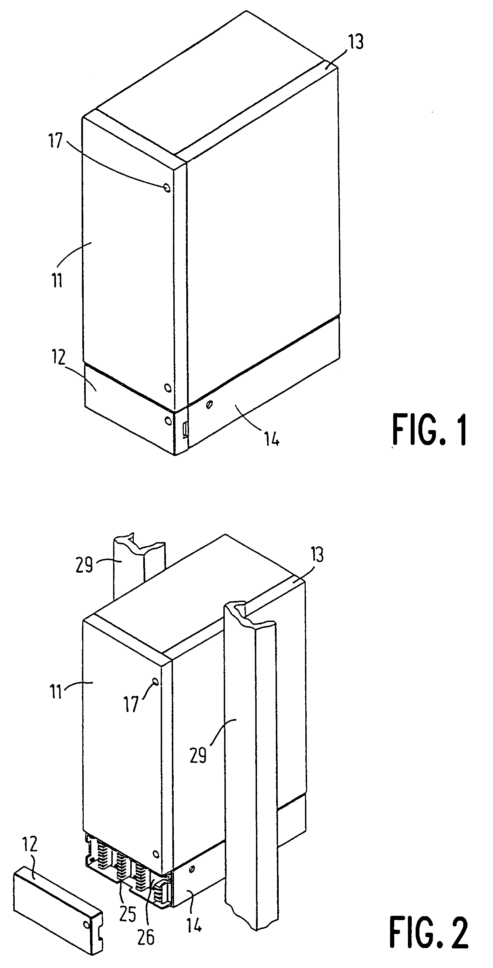

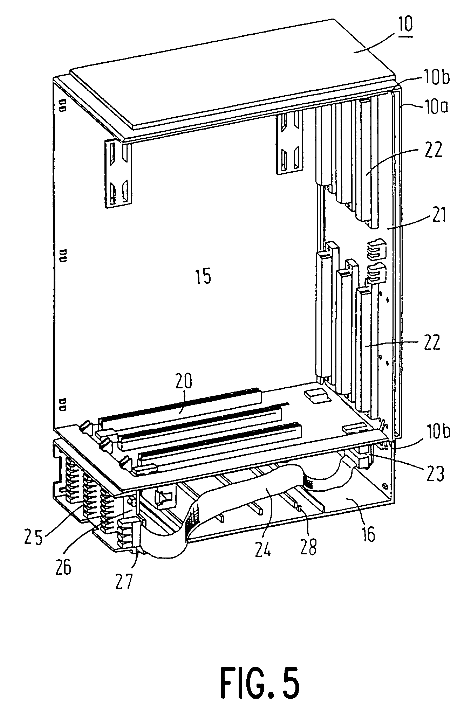

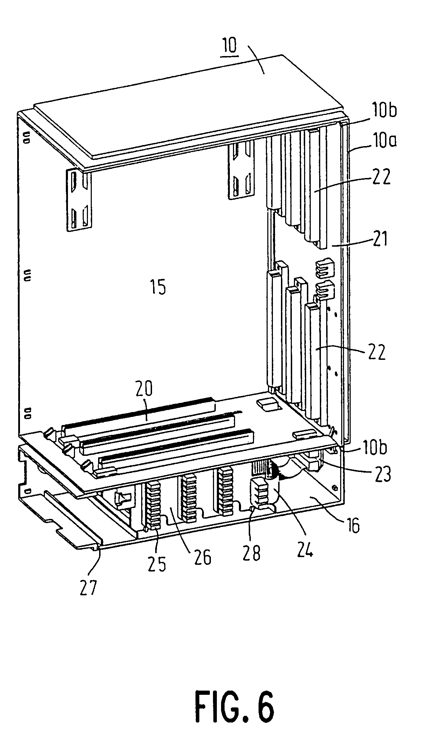

Das Gehäuse gemäß Fig. 1 bis 7 ist aus Kunststoff-Spritzgußteilen mit integrierten Funktionalitäten hergestellt. Dieses Gehäuse besitzt gemäß Fig. 5 und 6 ein einteiliges Grundgehäuse 10, das von seiner offenen Stirnseite durch Deckel 11, 12 und an seiner offenen Breitseite durch Deckel 13, 14 verschließbar ist (siehe Fig. 1 bis 4). Das Grundgehäuse 10 besitzt im oberen Bereich einen Leiterplattenbauraum 15, der durch den nach der Fertigung nicht mehr zu öffnenden Deckel 13 sowie durch den nachträglich demontierbaren Deckel 11 verschlossen wird. Im unteren Bereich befindet sich ein Anschlußbauraum 16 für ein weiter unten beschriebenes Anschlußfeld mit Verkabelung. Dieser Bauraum 16 wird durch die nachträglich abnehmbaren Deckel 12, 14 verschlossen. Alle abnehmbaren Deckel 11, 12, 14 sind in diesem Ausführungsbeispiel aus Gründen der elektrischen Sicherheit durch Befestigungselemente, z.B. Schrauben 17, gesichert (siehe Fig. 1 bis 3).

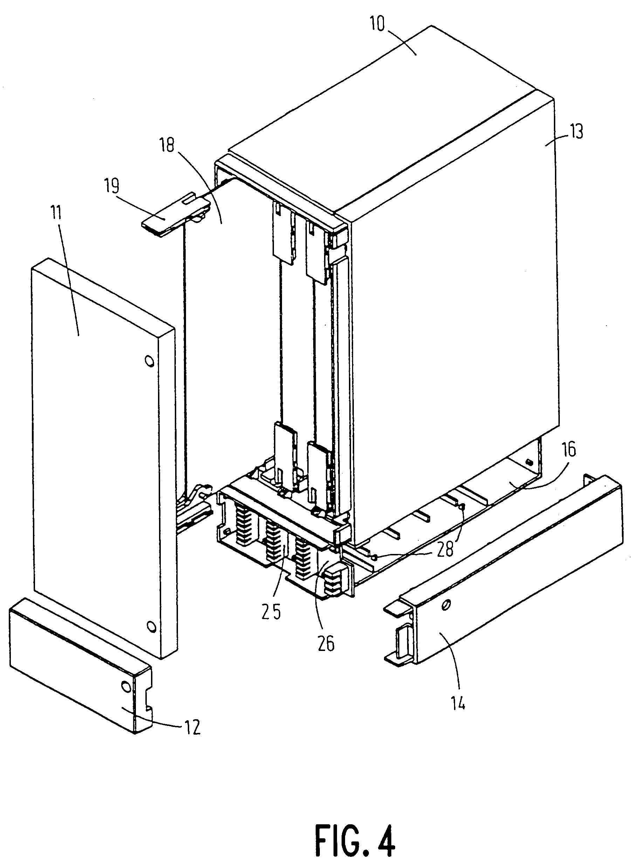

Gemäß Fig. 4 bis 6 sind in den Leiterplattenbauraum 15 Steckbaugruppen 18 in Form von Einsteckplatten einschiebbar, die an der Vorderseite Hebel 19 als Steck- und Ziehhilfen tragen. Mit 20 sind Führungsschienen für die Leiterplatten 18 bezeichnet. Parallel zur Rückwand 10a des Gehäuses ist eine Rückwandleiterplatte 21 angeordnet, die über Nuten 10b in das Gehäuse eingeschoben wird. Die Rückwandleiterplatte 21 trägt Steckverbinder 22 für an der Rückseite der Leiterplatten 18 angeordnete Steckerstifte. Die Rückwandleiterplatte 21 ist mit einem in den Anschlußraum 16 ragenden Fortsatz 23 versehen, an welchem die Steckverbinder 22 elektrisch mit einem flexiblen Kabel 24 verbunden werden. Das flexible Kabel ist mit seinem anderen Ende mit Kabelverbindern 25 verbunden, die auf einer Anschlußleiterplatte 26 befestigt sind. Die Anschlußplatte 26 bildet mit ihren Kabelverbindern 25 ein Anschlußfeld für den Anschluß von externen, nicht dargestellten Kabeln. Die Anschlußleiterplatte 26 ist in Nuten 27 eingeschoben, die im unteren Anschlußraum 16 parallel zur Frontseite verlaufend angeordnet sind. Im Gegensatz zu Fig. 5 ist die Anschlußleiterplatte in Fig. 6 an der Breitseite angeordnet und ist hier über Klemmelemente 28 befestigt. Die Bauart gemäß Fig. 5 entspricht dem in Fig. 2 dargestellten Montagefall, bei dem es sich z.B. um den Einbau in einen sogenannten Kabelverzweiger handelt, der in seinem Innern vertikale Befestigungsschienen 29 aufweist. In diesem Einsatzfall ist das Gehäuse nur frontseitig zugänglich.

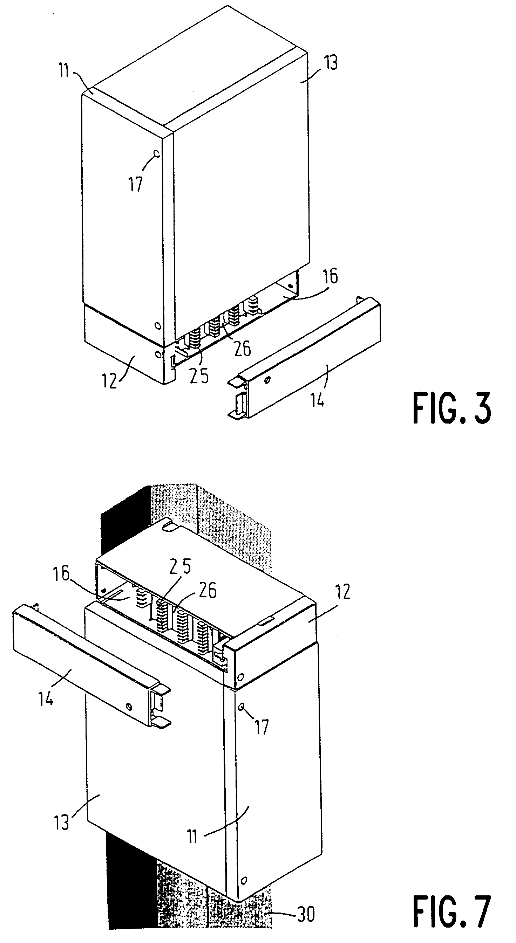

Die Bauart gemäß Fig. 6 entspricht dem Montagefall gemäß Fig. 3, bei dem das Gehäuse an einer Wand 30 montiert ist und der Anschluß wegen der guten Bedienbarkeit an der Breitseite erfolgt. In beiden Montagefällen muß gewährleistet sein, daß nachträglich Einsteckleiterplatten gesteckt und gezogen werden können und daß nachträglich zusätzliche Kabel eingebaut und angeschlossen werden können, ohne daß das Gerät außer Betrieb genommen werden muß.

Wenn in einem Sonderfall das Gerät in dem Ausführungsbeispiel gemäß Fig. 6 so montiert werden muß, daß die schmale Stirnseite nicht mehr zugänglich ist (z.B. wegen einer vorstehenden Wand), so kann das Gehäuse gemäß Fig. 7 um 180° gedreht montiert werden. Die Anschlußplatte 26 kann aber, da sie an der flexiblen Leitung 24 hängt, in der alten Ausrichtung eingeschnappt werden, damit vorhandene Steckerbeschriftungen nicht auf dem Kopf stehen.

Zusammenfassend ergibt sich somit der Vorteil, daß drei unterschiedliche Montagefälle mit verschiedenen Bedienungsrichtungen durch ein und dasselbe Gehäuse ermöglicht werden. Drehbare Aufhängungen oder dergl., die Instabilitäten und Verteuerungen mit sich bringen, werden vermieden. Das Gerät wird durch einfaches Umstecken der Anschlußleiterplatte vor Ort an den gegebenen Montagefall angepaßt, ohne daß dazu ein Werkzeug benötigt wird. Die durch die flexible Leitung 24 verbundene Rückwandleiterplatte 21 und Anschlußleiterplatte 26 bilden ein Bauteil. Dies vereinfacht die Endmontage des Gerätes erheblich, da keine nachträgliche interne Geräteverkabelung erforderlich ist.

Eine zweckmäßige Ausgestaltung der Erfindung besteht darin, daß die Rückwandleiterplatte 21 und die Anschlußleiterplatte 26 aus einer mit einer Soll-Bruchstelle versehenen, einteiligen Leiterplatte gefertigt sind, die bei der Endmontage an der Soll-Bruchstelle trennbar ist. Diese Bauweise bedeutet eine weitere Vereinfachung der Montage.

Die Endmontage des Gerätes ist sehr einfach und damit kostengünstig wie folgt durchzuführen:
- Die Rückwandleiterplatte 21 wird in das Grundgehäuse 10 eingeschoben,
- die über die flexible Leitung 24 mit der Rückwandleiterplatte 21 verbundene Anschlußleiterplatte 26 wird in den Kabelraum entweder eingeschoben (Fig. 5) oder eingeschnappt (Fig. 6),
- der Deckel 13 wird auf das Grundgehäuse 10 aufgeschnappt, und
- die Deckel 11, 12, 14 werden mit Hilfe der Befestigungselemente 17 montiert (oder in der Verpackung beigelegt, wenn das Gehäuse soweit vormontiert wurde).

Ferner kann ein recyclinggerechtes Zerlegen des Gerätes in die Fraktionen "Befestigungselemente" (z.B. Nirosta), "Kunststoffteile" (sortenrein) und "Leiterplatte" durchgeführt werden.

## Patentansprüche

1. Gehäuse für elektronische Steckbaugruppen (18), die von der Gehäusefrontseite her einschiebbar sind und im Bereich der Gehäuserückwand (10a) über Steckverbinder (22) kontaktierbar ausgebildet sind, wobei die Steckverbinder (22) auf ein Anschlußfeld (25, 26) herausgeführt sind, dadurch gekennzeichnet, daß das Anschlußfeld (25, 26) auf einer von der Rückwand (10a) getrennten, mit Kabelverbindern (25) versehenen gesonderten Anschlußleiterplatte (26) ausgebildet ist und daß die Kabelverbinder (25) elektrisch über eine flexible Leitung (24) mit den Steckverbindern (22) verbunden sind.

2. Gehäuse nach Anspruch 1, gekennzeichnet durch einen die Steckbaugruppen (18) aufnehmenden Leiterplattenbauraum (15) und einen davon getrennten, die Anschlußleiterplatte (26) und die flexible Leitung (24) aufnehmenden Anschlußbauraum (26).

3. Gehäuse nach Anspruch 1 oder 2, dadurch gekennzeichnet, daß die Anschlußleiterplatte (26) an der Frontseite oder im Bereich einer Seitenwand des Gehäuses angeordnet ist.

4. Gehäuse nach Anspruch 2 oder 3, dadurch gekennzeichnet, daß der Anschlußbauraum (16) mit parallel zur Fronseite verlaufenden Nuten (27) zur Aufnahme der Anschlußleiterplatte (26) versehen ist.

5. Gehäuse nach Anspruch 2 oder 3, dadurch gekennzeichnet, daß der Anschlußbauraum (16) im Bereich einer Seitenwand mit Befestigungselementen (Schnapphaken 28) zur Aufnahme der Anschlußleiterplatte (26) versehen ist.

6. Gehäuse nach einem der Ansprüche 1 bis 5, dadurch gekennzeichnet, daß der Leiterplattenbauraum (15) frontseitig und der Anschlußbauraum (16) frontseitig und/oder im Bereich einer Seitenwand jeweils mit einem Deckel (11, 12, 14) verschließbar ist.

7. Gehäuse nach einem der Ansprüche 1 bis 6, dadurch gekennzeichnet, daß die Steckverbinder (22) an einer gesonderten Rückwandleiterplatte (21) angeordnet sind, die in parallel zur Gehäuserückwand (10a) verlaufende Nuten einschiebbar ausgebildet ist und mit einem Fortsatz (23) zum Anschluß der flexiblen Leitung (24) in den Anschlußraum (16) ragt.

8. Gehäuse nach einem der Ansprüche 1 bis 7, dadurch gekennzeichnet, daß die Rückwandleiterplatte (21) und die Anschlußleiterplatte (26) aus einer mit einer Soll-Bruchstelle versehenen einteiligen Leiterplatte gefertigt sind, die bei der Endmontage an der Soll-Bruchstelle trennbar ist.

9. Gehäuse nach einem der Ansprüche 1 bis 8, dadurch gekennzeichnet, daß es aus Kunststoff-Spritzgußteilen mit integrierten Funktionselementen ausgebildet ist.
